# EUROPEAN PATENT APPLICATION

(11) **EP 4 601 187 A1**
(43) Date of publication of application: **13.08.2025**
(21) Application number: 25153452.5
(22) Date of filing: 23.01.2025
(51) Int. Cl.: H02P 29/024, H02H 3/027, H02H 3/093

(54) **EXCITER OVERCURRENT DETECTION DEVICE**

(30) Priority: 08.02.2024 KR 20240019584
(71) Applicant: Hyundai Mobis Co., Ltd., Gangnam-gu Seoul 06141 (KR)
(72) Inventor: KANG, Tae Hwan, 16891 Yongin-si (KR); CHOI, Yun Ho, 16891 Yongin-si (KR); PARK, Hyung Min, 16891 Yongin-si (KR); KIM, Yeon Ho, 16891 Yongin-si (KR); PARK, Joo Won, 16891 Yongin-si (KR); JO, Won Hee, 16891 Yongin-si (KR); CHO, Beom Cheol, 16891 Yongin-si (KR)
(74) Representative: Jung, Minkyu

(57) **Abstract**

Provided is an exciter overcurrent detection device. An overcurrent comparison part compares a current of an exciter and a reference current and output an overcurrent comparison signal. A filter outputs an overcurrent generation signal when an output value of the overcurrent comparison part maintains an overcurrent state value during a filter time. A counter cumulatively counts a time that the output value of the overcurrent comparison part corresponds to the overcurrent state value. A comparator outputs the overcurrent generation signal when a counted value of the counter exceeds a threshold value.

## Description

### BACKGROUND

### FIELD

The present disclosure relates to an exciter overcurrent detection device, and more particularly, to an overcurrent detection device for an exciter included in a motor controller.

### DISCUSSION OF THE BACKGROUND

A resolver sensor refers to a sensor for measuring the position of a motor rotor. Such resolver sensors are used as position sensors for drive motors in applications that require high performance and high precision drive, such as vehicles, due to higher mechanical strength and durability compared to encoders. That is, resolvers are intended to measure the degree of rotation of rotating devices such as motors, engines, and the like. In general, resolver sensors in electric motor drive systems are used to detect the position of rotors in electric motor drive systems that require frequent speed changes or precise position control.

For operation of the resolver sensor, the motor controller may be provided with an exciter. Here, the exciter may transmit an excitation signal to the resolver sensor, the resolver sensor, upon receiving the excitation signal, may generate a sine signal and a cosine signal based on the excitation signal and transmit the sine signal and the cosine signal to the motor controller, and the motor controller may accordingly determine the position of the motor.

### SUMMARY

For precise motor control, prevention of resolver sensor malfunction, and the like, it is desirable to detect an overcurrent in an exciter included in a motor controller. Accordingly, it is an objective of the present disclosure to provide an exciter overcurrent detection device that enables accurate overcurrent detection even in various overcurrent situations.

An exciter overcurrent detection device according to the present disclosure includes: an overcurrent comparison part configured to compare a current of an exciter and a reference current and output an overcurrent comparison signal; a filter configured to output an overcurrent generation signal when an output value of the overcurrent comparison part maintains an overcurrent state value during a filter time; a counter configured to cumulatively count a time that the output value of the overcurrent comparison part corresponds to the overcurrent state value; and a comparator configured to output the overcurrent generation signal when a counted value of the counter exceeds a threshold value.

The exciter overcurrent detection device according to the present disclosure may further include an OR gate configured to receive the output of the filter and the output of the comparator to output a final overcurrent generation signal.

In the present disclosure, the counter may be configured to detect an overcurrent due to oscillation of the current of the exciter.

In the present disclosure, the counter may reset when a time corresponding to a set reset counter is reached.

In the present disclosure, the time corresponding to the reset counter may be an integer multiple of the filter time.

In the present disclosure, the filter time may be equal to the threshold value.

In the present disclosure, the filter may include a counter configured to count a time that the output value of the overcurrent comparison part maintains the overcurrent state value.

In the present disclosure, a controller of the exciter may be configured to turn off the exciter according to the overcurrent generation signal.

In the present disclosure, the controller of the exciter may be configured to periodically re-execute the exciter after the exciter is turned off.

An exciter overcurrent detection device according to the present disclosure includes: an overcurrent comparison part configured to compare a current of an exciter and a reference current and output an overcurrent comparison signal; a processor; and a memory connected to the memory and storing instructions to be executed by the processor, wherein when the instructions stored in the memory are executed by the processor, the instructions may enable the processor to: determine whether an output value of an overcurrent comparison part maintains an overcurrent state value during a filter time; accumulate a time that the output value of the overcurrent comparison part corresponds to the overcurrent state value and determine whether the accumulated time exceeds a threshold value; and determine that an overcurrent has occurred when the output value of the overcurrent comparison part maintains the overcurrent state value during the filter time, or when the accumulated time that the output value of the overcurrent comparison part corresponds to the overcurrent state value exceeds the threshold value.

The exciter overcurrent detection device according to an embodiment of the present disclosure may determine whether an overcurrent has occurred by determining whether an overcurrent state of an overcurrent comparison result is maintained for a predetermined period of time, and further determine whether an overcurrent has occurred due to oscillation by cumulatively counting the time of the overcurrent state, thereby enabling accurate overcurrent detection even in various overcurrent situations.

### BRIEF DESCRIPTION OF THE DRAWINGS

FIG. 1 illustrates the configuration of a motor system according to an embodiment of the present disclosure;
FIG. 2 illustrates the configuration of an exciter overcurrent detection device according to an embodiment of the present disclosure;
FIGS. 3 and 4 are example views illustrating an overcurrent detection operation using a filter of the exciter overcurrent detection device according to an embodiment of the present disclosure; and
FIGS. 5 to 7 are example views illustrating an overcurrent detection operation by a counter of the exciter overcurrent detection device according to an embodiment of the present disclosure.

### DETAILED DESCRIPTION OF THE ILLUSTRATED EMBODIMENTS

Hereinafter, an exciter overcurrent detection device according to an embodiment of the present disclosure will be described with reference to the accompanying drawings. In this process, thicknesses of lines in the drawings and sizes of constituent elements may be exaggerated for clarity and convenience. Further, the following terms are defined, in consideration of functions thereof in the present disclosure, and may be varied according to the intention of a user or an operator and customs. Therefore, the terms should be defined based on the contents of the entire specification.

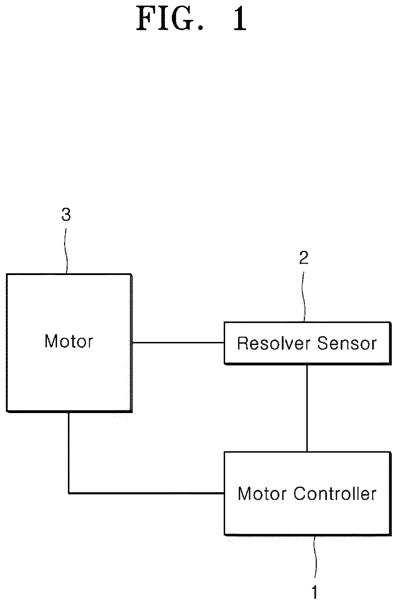

FIG. 1 illustrates the configuration of a motor system according to an embodiment of the present disclosure.

As shown in FIG. 1, a motor system includes a motor controller 1, a resolver sensor 2, and a motor 3.

The motor controller 1 may include an exciter that generates an excitation signal. For reference, it is understood that the excitation signal referred to in this detailed description refers collectively to signals applied to an object, and other terms such as excitation signal, stimulation signal, and the like may exist, but will be collectively referred to as the excitation signal in this detailed description.

The excitation signal generated by the exciter may be a sinusoidal signal with a constant frequency, and the exciter may include a square wave to sinusoidal converter to convert a square wave to a sinusoidal signal.

In addition, the excitation signal generated by the exciter may be transmitted to the resolver sensor 2. The resolver sensor 2 may be an analog angle detection sensor that converts the mechanical angular displacement of the motor 3 into an electrical signal using the phenomenon of electromagnetic induction. Furthermore, the resolver sensor 2 may be implemented to receive the excitation signal and then modulate the excitation signal using a stator coil to generate a reflected signal (i.e., a sine wave signal and/or a cosine wave signal).

The motor controller 1 may estimate the position of the rotor of the motor 3 based on such reflected signals to control the motor. For example, the motor controller may perform operations such as motor phase/speed detection, motor torque control, regenerative braking control, and the like.

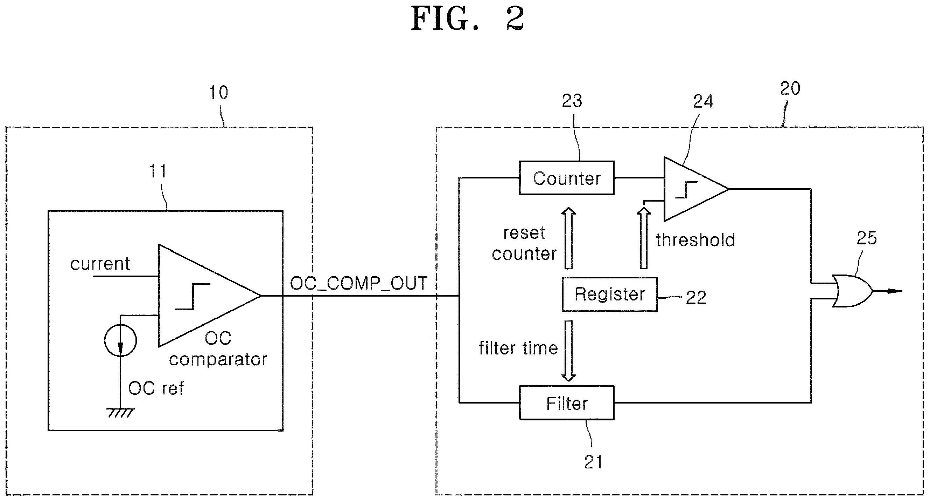

FIG. 2 illustrates the configuration of an exciter overcurrent detection device according to an embodiment of the present disclosure,

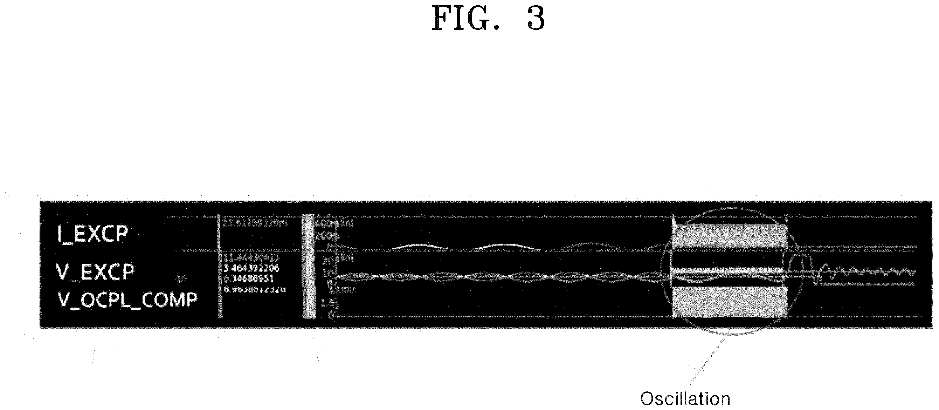

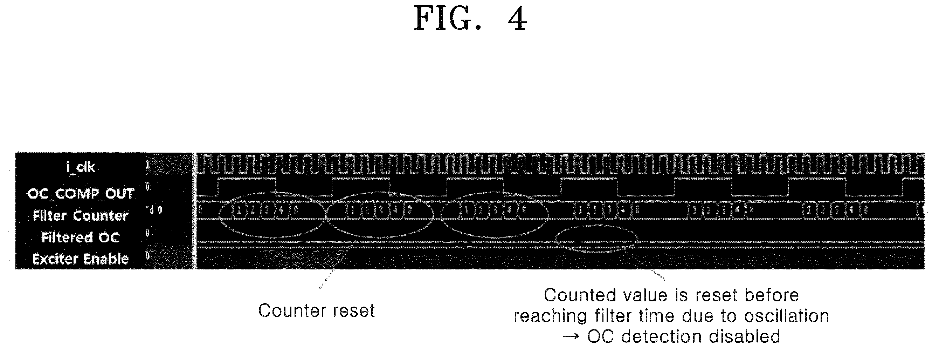

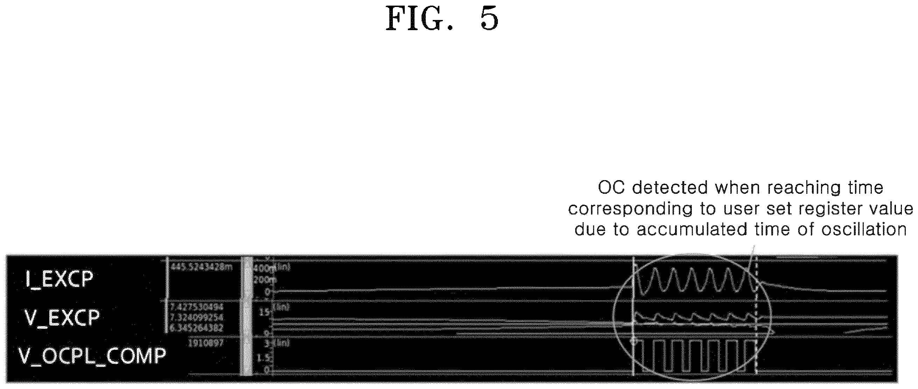

FIGS. 3 and 4 are example views illustrating an overcurrent detection operation using a filter of the exciter overcurrent detection device according to an embodiment of the present disclosure, and FIGS. 5 to 7 are example views illustrating an overcurrent detection operation by a counter of the exciter overcurrent detection device according to an embodiment of the present disclosure.

As shown in FIG. 2, the exciter overcurrent detection device may include an analog block 10 and a digital block 20. The analog block 10 and the digital block 20 may desirably be included within the motor controller 1.

The analog block 10 may include an overcurrent comparison part 11. The overcurrent comparison part may include an overcurrent (OC) comparator that receives an input of the exciter current and a reference current OC ref and outputs a comparison result OC_COMP_OUT thereof.

The output of the OC comparator may be set to have a high value when the exciter current is greater than the reference current OC ref and a low value when the exciter current is less than or equal to the reference current OC ref.

The current of the exciter input to the OC comparator may be a current corresponding to the current value of an output signal of the exciter (i.e., a signal sent to the resolver sensor 2, a current flowing in an FET of the exciter). In some embodiments, the exciter overcurrent detection device may be configured to detect whether a current flowing to other components of the exciter is an overcurrent.

The digital block 20 is a component that determines whether an actual overcurrent of the exciter has occurred, based on the output signal of the OC comparator (i.e., the output value of the overcurrent comparison part 11). That is, when the output value of the overcurrent comparison part 11 has a temporarily high value due to a temporary error, such as when the current of the exciter momentarily exceeds the reference current or when a spike or an overshoot occurs in the output of the overcurrent comparison part 11, it is desirable to determine that an actual overcurrent has not occurred.

A filter 21 is a component that filters such a transient overcurrent signal. The filter 21 may check whether the output value of the overcurrent comparison part 11 remains high for a predetermined period of time to determine whether an actual overcurrent has occurred.

For example, the filter 21 may include a counter (i.e., a first counter) that counts a time that the output of the overcurrent comparison part 11 remains high. The filter 21 may be configured to output a high signal to an OR gate 25 when the value of the counter exceeds a filter time set in a register 22. The counter may be configured to start counting when the output value of the overcurrent comparison part 11 is in a high state and to reset when the output value of the overcurrent comparison part 11 is in a low state.

However, the operation of the filter 21 described above may filter the output value of the overcurrent comparison part 11 as corresponding to a transient overcurrent signal even when the current of the exciter oscillates and exceeds the reference current.

In other words, as shown in FIGS. 3 and 4, when the current of the exciter oscillates, the output value of the overcurrent comparison part 11 is changed to a low state and the value of the counter is initialized due to oscillation before the filter time is reached, so that the signal is filtered and judged not to correspond to an overcurrent.

Regarding the oscillation phenomenon of the current of the exciter described above, oscillation may occur from a time point when the phase margin is zero (0) depending on the specific capacitance and inductance when the circuit is short-circuited according to the analog closed loop characteristics. When the oscillation duration exceeds a predetermined time, it is desirable to determine that an actual overcurrent has occurred even in this state.

The counter 23 (i.e., a second counter) of the digital block 20 may be configured to cumulatively count the time that the output value of the overcurrent comparison part 11 corresponds to a high state. The comparator 24 may be configured to compare the counted time of the counter 23 with a threshold value set in the register 22 and, when the counted time of the counter 23 exceeds the threshold value, output a high signal to the OR gate 25.

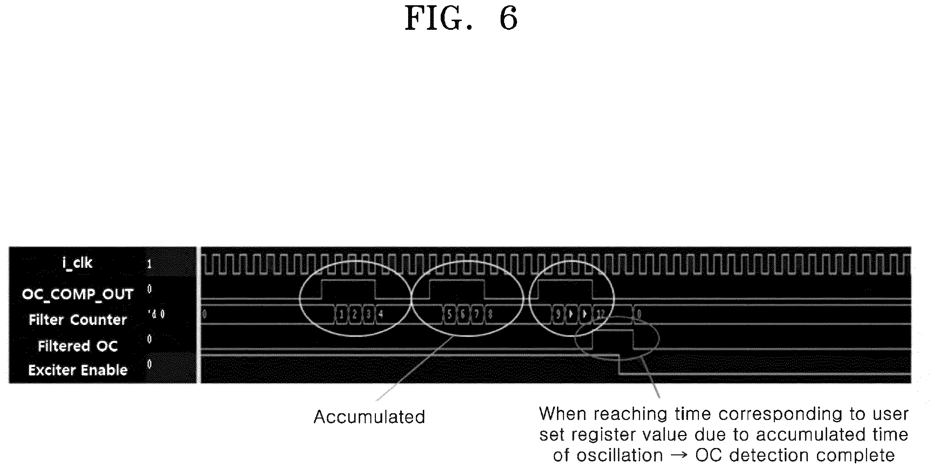

As shown in FIGS. 5 and 6, the oscillation signal may be cumulatively counted and, when the threshold value set in the register 22 is reached, may be determined to correspond to an overcurrent.

In some embodiments, the threshold value set in the register 22 may be the same value as the filter time.

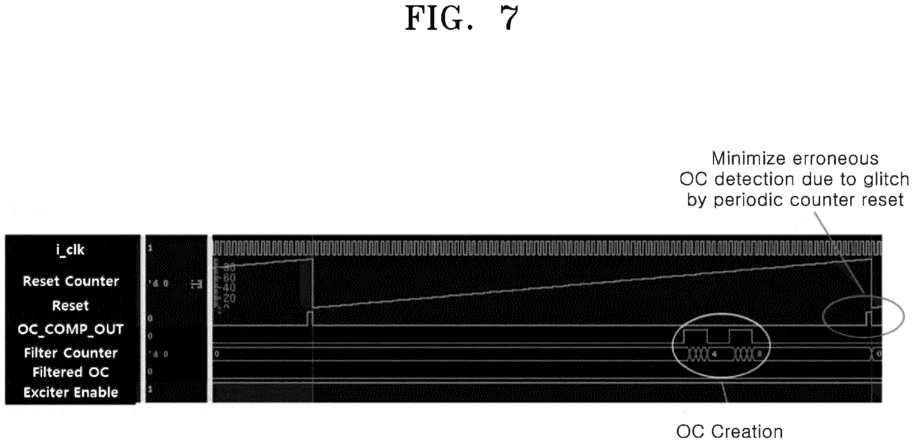

In addition, as shown in FIG. 7, the counter 23 may be configured to automatically reset after a time period corresponding to a reset counter set in the register 22 has elapsed. This is to prevent false detection of an overcurrent due to glitch.

The time corresponding to the reset counter may be configured to be set to an integer multiple of the filter time. For example, the time corresponding to the reset counter may be set to a time that is eight times the filter time. In this may, it may be configured to automatically set the values corresponding to the threshold and the reset counter described above even in the case that the user only sets a value corresponding to the filter time in the register 22.

The motor controller 1 may be configured to finally determine whether an overcurrent has occurred by an OR logic (i.e., the OR gate 25) based on the overcurrent determination result by the filter 21 and the overcurrent determination result by the counter 23.

The motor controller 1 may be configured to turn off the exciter when it is determined that an overcurrent has occurred. This operation may be configured to turn off the FET included in the exciter.

The motor controller 1 may also be configured to perform a periodic auto retry of the exciter when the exciter is turned off. That is, since the vehicle is likely to experience a momentary short circuit that appears and then disappears in the event of an overcurrent caused by current oscillation, the motor controller 1 may be configured to re-execute the exciter to redetermine whether an overcurrent has occurred.

In addition, the operation of the digital block 20 of the exciter overcurrent detection device described above may be configured to be implemented by a processor and a memory storing instructions to be executed by the processor. In this case, when the instructions stored in the memory are executed by the processor, the instructions may enable the processor to: determine whether the output value of the overcurrent comparison part 11 maintains an overcurrent state value (i.e., a high value) during the filter time; accumulate a time that the output value of the overcurrent comparison part 11 corresponds to the overcurrent state value and determine whether the accumulated time exceeds a threshold value; and determine that an overcurrent has occurred when the output value of the overcurrent comparison part 11 maintains the overcurrent state value during the filter time or when the accumulated time that the output value of the overcurrent comparison part 11 corresponds to the overcurrent state value exceeds the threshold value.

As set forth above, the exciter overcurrent detection device according to an embodiment of the present disclosure may determine whether an overcurrent has occurred by determining whether an overcurrent state of an overcurrent comparison result is maintained for a predetermined period of time, and further determine whether an overcurrent has occurred due to oscillation by cumulatively counting the time of the overcurrent state.

Although the foregoing embodiments have been provided to illustrate the present disclosure in conjunction with the accompanying drawings, it will be apparent to a person having ordinary skill in the art that the embodiments are given by way of illustration only, and that various modifications and equivalent embodiments can be made without departing from the spirit and scope of the present disclosure. Accordingly, the scope and spirit of the present disclosure should be defined only by the following claims.

## Claims

1. An exciter overcurrent detection device comprising:
an overcurrent comparison part configured to compare a current of an exciter and a reference current and output an overcurrent comparison signal;
a filter configured to output an overcurrent generation signal when an output value of the overcurrent comparison part maintains an overcurrent state value during a filter time;
a counter configured to cumulatively count a time that the output value of the overcurrent comparison part corresponds to the overcurrent state value; and
a comparator configured to output the overcurrent generation signal when a counted value of the counter exceeds a threshold value.

2. The exciter overcurrent detection device of claim 1, further comprising an OR gate configured to receive the output of the filter and the output of the comparator to output a final overcurrent generation signal.

3. The exciter overcurrent detection device of claim 1 or 2, wherein the counter is configured to detect an overcurrent due to oscillation of the current of the exciter.

4. The exciter overcurrent detection device of any one of claims 1 to 3, wherein the counter resets when a time corresponding to a set reset counter is reached.

5. The exciter overcurrent detection device of claim 4, wherein the time corresponding to the reset counter is an integer multiple of the filter time.

6. The exciter overcurrent detection device of any one of claims 1 to 5, wherein the filter time is equal to the threshold value.

7. The exciter overcurrent detection device of any one of claims 1 to 6, wherein the filter comprises a counter configured to count a time that the output value of the overcurrent comparison part maintains the overcurrent state value.

8. The exciter overcurrent detection device of any one of claims 1 to 7, wherein a controller of the exciter is configured to turn off the exciter according to the overcurrent generation signal.

9. The exciter overcurrent detection device of claim 8, wherein the controller of the exciter is configured to periodically re-execute the exciter after the exciter is turned off.

10. An exciter overcurrent detection device comprising:
an overcurrent comparison part configured to compare a current of an exciter and a reference current and output an overcurrent comparison signal;
a processor; and
a memory connected to the memory and storing instructions to be executed by the processor,
wherein when the instructions stored in the memory are executed by the processor, the instructions enable the processor to:
determine whether an output value of an overcurrent comparison part maintains an overcurrent state value during a filter time;
accumulate a time that the output value of the overcurrent comparison part corresponds to the overcurrent state value and determine whether the accumulated time exceeds a threshold value; and
determine that an overcurrent has occurred when the output value of the overcurrent comparison part maintains the overcurrent state value during the filter time, or when the accumulated time that the output value of the overcurrent comparison part corresponds to the overcurrent state value exceeds the threshold value.
